(19) Europäisches Patentamt
European Patent Office
Office européen des brevets

(11) **EP 1 955 081 B1**

(12) **FASCICULE DE BREVET EUROPEEN**

(45) Date de publication et mention
de la délivrance du brevet:
**29.04.2015 Bulletin 2015/18**

(21) Numéro de dépôt: **06820322.3**

(22) Date de dépôt: **19.10.2006**

(51) Int Cl.:
*G01R 19/00* *(2006.01)*  *G01R 15/18* *(2006.01)*

(86) Numéro de dépôt international:
**PCT/FR2006/051066**

(87) Numéro de publication internationale:
**WO 2007/060347 (31.05.2007 Gazette 2007/22)**

(54) **MESURE DEPORTEE DU COURANT TRAVERSANT UNE CHARGE**

OUT-OF-LINE-MESSUNG EINES DURCH EINE LAST FLIESSENDEN STROMS

OUT-OF-LINE MEASUREMENT OF A CURRENT FLOWING THROUGH A LOAD

(84) Etats contractants désignés:
**AT BE BG CH CY CZ DE DK EE ES FI FR GB GR HU IE IS IT LI LT LU LV MC NL PL PT RO SE SI SK TR**

(30) Priorité: **28.11.2005 FR 0512039**

(43) Date de publication de la demande:
**13.08.2008 Bulletin 2008/33**

(73) Titulaire: **Renault s.a.s.**
**92100 Boulogne Billancourt (FR)**

(72) Inventeurs:
• **AGNERAY, André**
**F-92100 Boulogne Sur Seine (FR)**

• **NOUVEL, Clément**
**F-78480 Verneuil Sur Seine (FR)**

(74) Mandataire: **Rougemont, Bernard et al**
**Renault s.a.s**
**Technocentre**
**Sce 00267 TCR GRA 2 36**
**1, Avenue du Golf**
**78288 Guyancourt (FR)**

(56) Documents cités:
**EP-A- 0 825 343     EP-A- 1 515 408**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

L'invention concerne l'alimentation de charges résonantes par des tensions supérieures à 300 V et à des fréquences supérieures à 1 MHz et en particulier les mesures du courant traversant de telles charges.

Notamment pour une application à l'allumage automobile à génération de plasma, des résonateurs dont la fréquence de résonance est supérieure à 1 MHz sont disposés au niveau de la bougie et sont typiquement alimentés avec des tensions supérieures à 300 V et soumis à une intensité supérieure à 5 A. Cette application nécessite l'utilisation de résonateurs radio-fréquence présentant un facteur de qualité élevé et un générateur haute tension dont la fréquence de fonctionnement est très proche de la fréquence de résonance du résonateur. Plus la différence entre la fréquence de résonance du résonateur et la fréquence de fonctionnement du générateur est réduite, plus le facteur d'amplification du résonateur (rapport entre sa tension de sortie et sa tension d'entrée) est élevé. Plus le facteur de qualité du résonateur est élevé, plus la fréquence de fonctionnement du générateur doit être proche de sa fréquence de résonance.

De nombreux paramètres ont une incidence sur la fréquence de résonance : les dispersions de fabrication, la température dans la chambre de combustion ou dans le circuit de refroidissement ou les dérives de vieillissement des composants du résonateur. L'évolution. de la fréquence de résonance est ainsi difficile à prévoir ou à maîtriser.

Des techniques d'asservissement permettent de maintenir une tension d'alimentation à une fréquence proche de la fréquence de résonance du résonateur. Une technique consiste notamment à effectuer des mesures de courant et de tension durant l'alimentation du résonateur. La mesure du déphasage entre le courant et la tension en sortie du résonateur permet de réaliser l'asservissement.

Le document EP 1515408 décrit une bougie de génération de plasma à inductance intégrée.

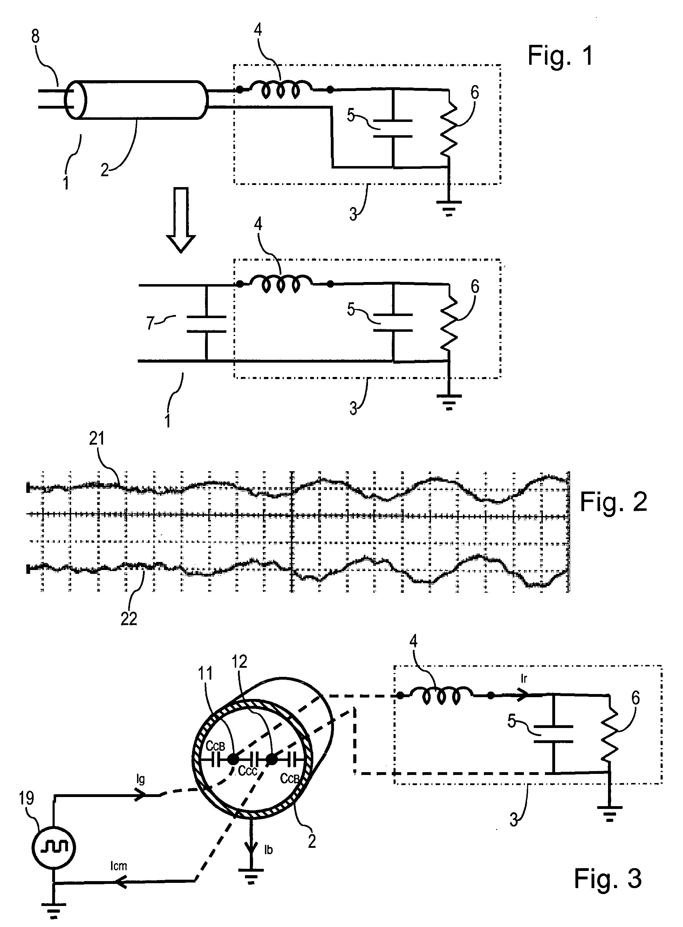

Comme illustré à la figure 1, un dispositif connu comprend un câble 1 connectant le générateur à un résonateur 3. Le câble 1 comprend des conducteurs 8 et un blindage 2. Le résonateur 3 comprend une inductance 4, un condensateur 5 et une résistance 6. Afin de limiter le nombre de conducteurs entre le résonateur et le générateur, un dispositif de mesure de courant est disposé au niveau du générateur. Cependant, le câble 1 introduit des capacités parasites, illustrées par la capacité 7 dans la représentation électrique équivalente de la figure 1. Des courants de fuite apparaissent alors dans le câble et modifient fortement la forme du courant mesuré à la sortie du générateur.

Comme illustré à la figure 2, le signal de mesure 22 en sortie du générateur est déphasé par rapport au courant 21 en entrée du résonateur 3. De plus, ce signal 22 est influencé par des résonances parasites hautes fréquences dues aux couplages entre le résonateur et les capacités parasites du câble 1. Les performances de l'asservissement sont alors fortement dégradées. Aucune solution connue ne permet d'améliorer la précision du signal de mesure au niveau du générateur pour de telles valeurs de fréquence.

L'invention vise à résoudre un ou plusieurs de ces inconvénients. L'invention propose ainsi un circuit de mesure du courant traversant une charge, comprenant : un câble présentant, entre des première et deuxième extrémités, des premier et deuxième conducteurs et un blindage, les conducteurs étant aptes à être connectés à une charge au niveau de la première extrémité et à un générateur au niveau de la seconde extrémité, le blindage n'étant pas relié à une masse au niveau de la première extrémité ;

- un transformateur présentant au moins des premier, deuxième et troisième enroulements, le premier enroulement étant connecté à un conducteur au niveau de la seconde extrémité du câble, le deuxième enroulement étant connecté entre une masse et le blindage au niveau de la deuxième extrémité du câble, le troisième enroulement étant apte à être connecté à un organe de mesure de courant.

D'autres caractéristiques et avantages de l'invention ressortiront clairement de la description qui en est faite ci-après, à titre indicatif et nullement limitatif, en référence aux dessins annexés, dans lesquels :

- la figure 1 illustre la connexion d'un résonateur par l'intermédiaire d'un câble et son équivalent électrique ;
- la figure 2 illustre le courant en entrée de résonateur et le signal mesuré au niveau du générateur ;
- la figure 3 illustre les capacités et courants parasites dans un câble de connexion ;
- la figure 4 illustre un câble de connexion et un dispositif de mesure selon un mode de réalisation de l'invention ;
- la figure 5 illustre un câble de connexion et un dispositif de mesure selon une variante de l'invention.

L'invention propose de mesurer le courant débité dans une charge résonante par l'intermédiaire d'un câble blindé. La mesure est effectuée au niveau de la connexion du câble à un générateur, au moyen d'un transformateur à 3 enroulements. On utilise les courants traversant le blindage du câble, ces courants étant proportionnels aux capacités parasites du câble. Un des enroulements du transformateur récupère .les courants traversant le blindage afin de compenser au niveau d'un organe de mesure les fuites dues aux capacités parasites du câble.

Ainsi, une mesure précise du courant débité dans la charge résonante peut être effectuée sans nécessiter une sonde de mesure au niveau de la charge et un câble supplémentaire pour conduire ce signal jusqu'au niveau du générateur.

La figure 3 illustre un câble 1 connecté au niveau d'une première extrémité à un résonateur 3 et connecté au niveau d'une deuxième extrémité à un générateur 19. Le câble 1 comprend un premier conducteur 11 connecté à une borne haute tension du générateur 19, un second conducteur 12 connecté à une masse, et un blindage. Le générateur est apte à débiter une tension d'alimentation d'une fréquence supérieure à 1 MHz, la fréquence de résonance du résonateur étant également supérieure à 5MHz.

Les capacités Ccb sont dérivées de la capacité linéique de chaque conducteur 11 ou 12 par rapport au blindage. La capacité Ccc est dérivée de la capacité linéique entre les conducteurs 11 et 12. En considérant que les longueurs d'onde sont très grandes par rapport à la longueur du câble (pour un câble destiné à un allumage automobile, la longueur du câble sera généralement comprise entre 100 et 1500 mm), on en déduit les équations suivantes :

$$Ig=Icm+Ib$$

$$Icm=Ir+Icc$$

$$Ib=Icb=Icc*Ccc/Ccb$$

$$Ir=Icm-Icc=Ig- \; Ib*Ccb/Ccc \; -Ib=Ig-(1+ \; Ccb/Ccc)*Ib$$

Avec :

Ig le courant débité par le générateur dans le conducteur 11, Icm le courant sortant du conducteur 12 au niveau de la seconde extrémité du câble, Ib le courant entre le blindage et la masse, Ir le courant injecté à l'entrée du résonateur, Icc le courant dans les capacités Ccc et Icb le courant dans les capacités Ccb.

La relation Ig=Icm+Ib signifie qu'il n'y a pas de courant circulant du culot de la bougie directement vers la masse. Ce résultat est par exemple obtenu par l'adjonction d'un circuit magnétique enserrant les conducteurs dans lesquels passent les courants Ig, Icm et Ib en amont du connecteur. Ce résultat peut également être obtenu par l'adjonction d'une bague de ferrite autour du câble.

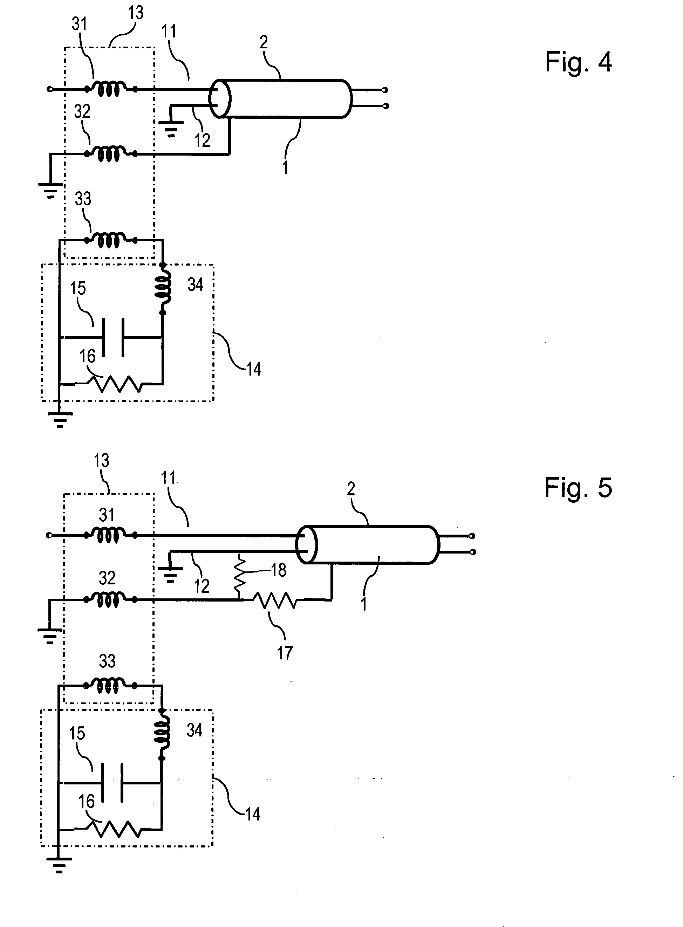

La figure 4 illustre un mode de réalisation d'un circuit de mesure selon l'invention, utilisant le courant Ib pour corriger une mesure de courant effectuée au niveau de la seconde extrémité du câble. Le circuit de mesure comprend un câble 1 tel que détaillé auparavant et un transformateur à trois enroulements 13. On peut notamment utiliser un câble à paire torsadée blindée. Les conducteurs 11 et 12 sont destinés à être connectés au résonateur au niveau d'une première extrémité du câble, et au générateur au niveau d'une seconde extrémité du câble.

Le premier enroulement 31 du transformateur 13 est destiné à être connecté entre une sortie haute tension d'un générateur et le conducteur 11 au niveau de la seconde extrémité du câble 1. Le courant traversant l'enroulement 31 est la somme du courant traversant le résonateur et des courants induits par les capacités parasites du câble 1. Le conducteur 12 est connecté à une masse, de préférence au niveau des deux extrémités du câble 1. Le second enroulement 32 du transformateur est connecté entre une masse et le blindage 2 au niveau de la seconde extrémité du câble. Le blindage 2 n'est pas connecté électriquement au niveau de la première extrémité du câble. Le second enroulement 32 est traversé par un courant représentatif des courants induits par les capacités parasites du câble. Le troisième enroulement 33 est connecté aux bornes d'un organe de mesure de courant 14, typiquement un circuit RC. L'organe de mesure 14 illustré comprend un condensateur 15 et une résistance 16. L'inductance 34 représente l'inductance de fuite du transformateur.

L'enroulement 33 sert à réaliser la mesure de courant de façon connue en soi. Les enroulements 31 et 32 présentent des sens d'enroulements contraires, afin que le courant Ib compense la différence entre le courant Ig et le courant Ir dans le signal mesuré. Le courant traversant le troisième enroulement 33 est ainsi plus représentatif du courant Ir traversant le résonateur.

Pour former un dispositif d'alimentation d'un résonateur avec un asservissement en fréquence, on accole au circuit de mesure un générateur muni d'un organe d'asservissement en fréquence récupérant le signal de mesure fourni par l'organe de mesure 14. De façon connue en soi, l'organe d'asservissement modifie la fréquence de la tension d'alimentation en fonction de ce signal de mesure, par exemple en déterminant au préalable la phase entre le signal de mesure et la tension d'alimentation.

Ce dispositif d'alimentation est avantageusement utilisé pour former un système de génération de plasma avec un résonateur alimentant deux électrodes. Le dispositif d'alimentation peut ainsi alimenter un résonateur présentant une fréquence supérieure à 1 MHz, un plasma étant formé entre ces deux électrodes en présence de la tension d'alimentation. Le résonateur peut notamment'être une bobine-bougie d'allumage automobile.

La figure 5 illustre une autre variante de circuit de mesure optimisant la compensation et adaptée pour obtenir le rapport de compensation souhaité sans limitation par le nombre de spires de l'enroulement 32. Dans cette variante, un pont résistif dérive une partie du courant de la branche de compensation directement vers la masse. Dans l'exemple illustré, une compensation optimale est obtenue avec des valeurs appropriées R17 et R18 des liaisons résistives 17 et 18.

En effet, des calculs et des mesures permettent de déduire que, même en utilisant un même nombre de spires dans les enroulements 31 et 32, la compensation des courants parasites n'est pas complète. Ce phénomène peut être expliqué par la différence entre la capacité linéique entre conducteurs et la capacité linéique entre un conducteur et le blindage. En effet, le rapport R18/(R17+R18) est sensiblement égal au rapport Icb/(Icc+Icb) divisé par le rapport de transformation entre l'enroulement 31 et l'enroulement 32. Dans l'hypothèse où l'enroulement 32 est en fait dédoublé alors que l'enroulement 31 ne l'est pas, la compensation n'est exacte que si le courant Icc est égal au courant Icb, ce qui n'est pas vérifié du fait des différences de capacités linéiques. Un pont de résistances est ainsi utilisé pour ajuster ce rapport. Le dimensionnement du pont de résistances peut être effectué sur la base des capacités linéiques du câble.

Afin d'optimiser la compensation, on peut également adapter le nombre de spires de l'enroulement 32 par rapport à l'enroulement 31 de façon adéquate.

Par ailleurs, les liaisons résistives 17 et 18 et les capacités parasites du câble peuvent réduire la bande passante dans l'enroulement 32 par filtrage RC, ce qui peut altérer la compensation aux fréquences d'utilisation. On inclura alors avantageusement des composants réactifs adéquats dans les liaisons 17 et 18 afin d'optimiser le comportement dynamique du circuit de mesure.

Le circuit RC est avantageusement configuré avec l'inductance de fuite 34 de façon à former un filtre dont la bande passante est centrée sur la fréquence de résonance du résonateur, et de sorte que la tension aux bornes de la résistance ne sorte pas de la plage de tension de l'organe d'asservissement.

L'inductance de l'enroulement 31 ne doit pas être surdimensionnée afin de ne pas affecter le comportement du dispositif d'alimentation en boucle ouverte. En pratique, le transformateur 13 peut présenter un tore de petite dimension (diamètre extérieur d'environ 20mm), réalisé dans un matériau magnétique conservant ses propriétés à la fréquence de travail tel que de la ferrite 4C65. Avec un enroulement 31 à une seule spire, l'inductance peut être limitée à 30 nH. Afin de limiter l'intensité traversant l'enroulement 33, celui-ci présentera de préférence un nombre de spires très supérieur au nombre de spires de l'enroulement 31, par exemple 20 spires dans l'exemple qui précède.

**Revendications**

**1.** Circuit de mesure du courant traversant une charge, il comprend :

- un câble (1) présentant, entre des première et deuxième extrémités, des premier et deuxième conducteurs (11, 12) et un blindage (2), les conducteurs étant aptes à être connectés à une charge (3) au niveau de la première extrémité et à un générateur (19) au niveau de la seconde extrémité, le blindage n'étant pas relié à une masse au niveau de la première extrémité ; **caractérisé en ce qu'**il comprend :
- un transformateur (3) présentant au moins des premier, deuxième et troisième enroulements (31 à 33), le premier enroulement étant connecté à un conducteur au niveau de la seconde extrémité du câble, le deuxième enroulement étant connecté entre une masse et le blindage au niveau de la deuxième extrémité du câble, le troisième enroulement étant apte à être connecté à un organe de mesure de courant (14).

**2.** Circuit de mesure de courant selon la revendication 1, comprenant l'organe de mesure de courant (14) connecté aux bornes du troisième enroulement (33).

**3.** Circuit de mesure de courant selon la revendication 2, dans lequel l'organe de mesure de courant (14) comprend un circuit RC.

**4.** Dispositif d'alimentation d'une charge, comprenant : comprenant :

- un circuit de mesure de courant selon la revendication 3;
- un générateur (19), connecté aux premier et seconds conducteurs (11, 12) au niveau de la seconde extrémité du câble (1) et apte à leur fournir une tension d'alimentation d'une fréquence supérieure à 1 MHz, le générateur (19) comprenant un organe d'asservissement en fréquence connecté à l'organe de mesure et modifiant la fréquence de la tension d'alimentation en fonction du signal fourni par l'organe de mesure.

5. Dispositif d'alimentation selon la revendication 4, dans lequel le premier enroulement (31) est connecté entre une sortie haute tension du générateur et le premier conducteur (11).

6. Dispositif d'alimentation selon la revendication 5, dans lequel les premier et deuxième enroulements (31, 32) présentent des sens d'enroulement contraires.

7. Dispositif d'alimentation selon la revendication 5 ou 6, comprenant une résistance (17, 18) connectée entre le blindage (2) et le second conducteur (12) au niveau de la seconde extrémité.

8. Dispositif d'alimentation selon la revendication 7, comprenant un composant réactif connecté entre le blindage et le second conducteur au niveau de la seconde extrémité.

9. Système de génération de plasma, comprenant :

- un dispositif selon l'une quelconque des revendications 4 à 8 ;
- une charge présentant une fréquence de résonance supérieure à 1 MHz, connectée aux conducteurs du câble au niveau de la première extrémité, comprenant deux électrodes et apte à générer un plasma entre les deux électrodes lorsque le générateur délivre sa tension d'alimentation.

**Patentansprüche**

1. Schaltung zum Messen des durch eine Last fließenden Stroms, umfassend:

- ein Kabel (1), das zwischen einem ersten und zweiten Ende einen ersten und zweiten Leiter (11, 12) und eine Abschirmung (2) aufweist, wobei die Leiter geeignet sind, an eine Last (3) an dem ersten Ende und an einen Generator (19) an dem zweiten Ende angeschlossen zu werden, wobei die Abschirmung an dem ersten Ende nicht mit einer Masse verbunden ist;

**dadurch gekennzeichnet, dass** sie

- einen Transformator (3) aufweist, der mindestens eine erste, zweite und dritte Wicklung (31 bis 33) aufweist, wobei die erste Wicklung an einen Leiter an dem zweiten Ende des Kabels angeschlossen ist, wobei die zweite Wicklung zwischen einer Masse und der Abschirmung an dem zweiten Ende des Kabels angeschlossen ist, wobei die dritte Wicklung geeignet ist, an ein Organ zur Strommessung (14) angeschlossen zu werden.

2. Schaltung zum Strommessen nach Anspruch 1, umfassend das Organ zur Strommessung (14), das an die Klemmen der dritten Wicklung (33) angeschlossen ist.

3. Schaltung zum Strommessen nach Anspruch 2, wobei das Organ zur Strommessung (14) eine RC-Schaltung aufweist.

4. Vorrichtung zur Versorgung einer Last, umfassend:

- eine Schaltung zum Strommessen nach Anspruch 3;
- einen Generator (19), der an dem ersten und zweiten Leiter (11, 12) an dem zweiten Ende des Kabels (1) angeschlossen ist und geeignet ist, ihnen eine Versorgungsspannung mit einer Frequenz von über 1 MHz zu liefern, wobei der Generator (19) eine Frequenznachführungsvorrichtung aufweist, die an das Organ zur Messung angeschlossen ist und die Frequenz der Versorgungsspannung gemäß dem Signal modifiziert, das von dem Organ zur Messung geliefert wird.

5. Vorrichtung zur Versorgung nach Anspruch 4, wobei die erste Wicklung (31) zwischen einem Hochspannungsausgang des Generators und dem ersten Leiter (11) angeschlossen ist.

6. Vorrichtung zur Versorgung nach Anspruch 5, wobei die erste und die zweite Wicklung (31, 32) entgegengesetzte Wicklungsrichtungen aufweisen.

**7.** Vorrichtung zur Versorgung nach Anspruch 5 oder 6, umfassend einen Widerstand (17, 18), der zwischen der Abschirmung (2) und dem zweiten Leiter (12) an dem zweiten Ende angeschlossen ist.

**8.** Vorrichtung zur Versorgung nach Anspruch 7, umfassend eine reaktive Komponente, die zwischen der Abschirmung und dem zweiten Leiter an dem zweiten Ende angeschlossen ist.

**9.** Plasmaerzeugungssystem, umfassend:

- eine Vorrichtung nach einem der Ansprüche 4 bis 8;
- eine Last, die eine Resonanzfrequenz von über 1 MHz aufweist, die mit den Leitern des Kabels an dem ersten Ende verbunden ist, die zwei Elektroden aufweist und die geeignet ist, ein Plasma zwischen den zwei Elektroden zu erzeugen, wenn der Generator seine Versorgungsspannung liefert.

**Claims**

**1.** Circuit for measuring the current flowing through a load, which comprises:

- a cable (1) having, between the first and second ends, first and second conductors (11, 12) and a shield (2), the conductors being able to be connected to a load (3) at the first end and to a generator (19) at the second end, the shield not being connected to ground at the first end;
- **characterized in that** it comprises:

- a transformer (3) having at least first, second and third windings (31 to 33), the first winding being connected to a conductor at the second end of the cable, the second winding being connected between ground and the shield at the second end of the cable, the third winding being able to be connected to a current measuring device (14).

**2.** Current measurement circuit according to Claim 1, comprising the current measuring device (14) connected to the terminals of the third winding (33).

**3.** Current measurement circuit according to Claim 2, wherein the current measuring device (14) comprises an RC circuit.

**4.** Device for supplying power to a load, comprising:

- a current measurement circuit according to Claim 3;
- a generator (19) connected to the first and second conductor (11, 12) at the second end of the cable (1) and able to provide them with a supply voltage at a frequency higher than 1 MHz, the generator (19) comprising a frequency control circuit connected to the measuring device and modifying the frequency of the supply voltage as a function of the signal provided by the measuring device.

**5.** Power supply device according to Claim 4, in which the first winding (31) is connected between a high-voltage output of the generator and the first conductor (11).

**6.** Power supply device according to Claim 5, in which the first and second windings (31, 32) being wound in opposing directions.

**7.** Power supply device according to Claim 5 or 6, comprising a resistor (17, 18) connected between the shield (2) and the second conductor (12) at the second end.

**8.** Power supply device according to Claim 7, comprising an active component connected between the shield and the second conductor at the second end.

**9.** Plasma generation system comprising:

- a device according to any one of the Claims 4 to 8; and
- a load having a resonant frequency higher than 1 MHz, connected to the conductors of the cable at the first end, comprising two electrodes and able to generate a plasma between the two electrodes when the generator delivers its supply voltage.

Fig. 1

Fig. 2

Fig. 3

Fig. 4

Fig. 5

**EP 1 955 081 B1**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1515408 A